(19) Europäisches Patentamt / European Patent Office / Office européen des brevets

(11) **EP 2 666 026 B1**

(12) **FASCICULE DE BREVET EUROPEEN**

(45) Date de publication et mention de la délivrance du brevet:
**27.05.2015 Bulletin 2015/22**

(21) Numéro de dépôt: **11820859.4**

(22) Date de dépôt: **15.12.2011**

(51) Int Cl.:
***G01R 31/11*** *(2006.01)*

(86) Numéro de dépôt international:
**PCT/EP2011/072953**

(87) Numéro de publication internationale:
**WO 2012/097932 (26.07.2012 Gazette 2012/30)**

(54) **PROCEDE ET DISPOSITIF D'ESTIMATION DE LA REPONSE IMPULSIONNELLE D'UN RESEAU DE CABLES PAR DECONVOLUTION MYOPE**

VERFAHREN UND GERÄT ZUR SCHÄTZUNG DER IMPULSANTWORT EINES KABELNETZWERKS UNTER VERWENDUNG VON HALBBLINDER ENTFALTUNG

PROCEDURE AND APPARATUS FOR ESTIMATING AN IMPULSE RESPONSE OF A CABLE NETWORK USING SEMI-BLIND DECONVOLUTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.01.2011 FR 1150501**

(43) Date de publication de la demande:
**27.11.2013 Bulletin 2013/48**

(73) Titulaire: **Commissariat à l'Énergie Atomique et aux Énergies Alternatives 75015 Paris (FR)**

(72) Inventeur: **LELONG, Adrien F-91400 Orsay (FR)**

(74) Mandataire: **Delaval, Guillaume Laurent Marks & Clerk France Immeuble Visium 22, avenue Aristide Briand 94117 Arcueil Cedex (FR)**

(56) Documents cités:
**GB-A- 2 458 654   US-A1- 2007 025 548**

- **BUCCELLA C ET AL: "Detection and Localization of Defects in Shielded Cables by Time-Domain Measurements With UWB Pulse Injection and Clean Algorithm Postprocessing", IEEE TRANSACTIONS ON ELECTROMAGNETIC COMPATIBILITY, IEEE SERVICE CENTER, NEW YORK, NY, US, vol. 46, no. 4, 1 novembre 2004 (2004-11-01), pages 597-605, XP011122832, ISSN: 0018-9375, DOI: 10.1109/TEMC.2004.837842 cité dans la demande**
- **POREE F ET AL: "Two bayesian methods for multipath propagation parameters estimation", ACOUSTICS, SPEECH, AND SIGNAL PROCESSING, 2000. ICASSP '00. PROCEEDINGS. 2000 IEEE INTERNATIONAL CONFERENCE ON 5-9 JUNE 2000, PISCATAWAY, NJ, USA,IEEE, vol. 1, 5 juin 2000 (2000-06-05), pages 69-72, XP010507270, ISBN: 978-0-7803-6293-2 cité dans la demande**
- **STEFAN SCHUET: "Wiring Diagnostics Via \ell_ 1-Regularized Least Squares", IEEE SENSORS JOURNAL, IEEE SERVICE CENTER, NEW YORK, NY, US, vol. 10, no. 7, 1 juillet 2010 (2010-07-01), pages 1218-1225, XP011310250, ISSN: 1530-437X cité dans la demande**
- **STEFAN R SCHUET ET AL: "A model-based probabilistic inversion framework for wire fault detection using TDR", INSTRUMENTATION AND MEASUREMENT TECHNOLOGY CONFERENCE (I2MTC), 2010 IEEE, IEEE, PISCATAWAY, NJ, USA, 3 mai 2010 (2010-05-03), pages 422-425, XP031691686, ISBN: 978-1-4244-2832-8 cité dans la demande**

Printed by Jouve, 75001 PARIS (FR)

**Description**

L'invention concerne un procédé et un dispositif d'estimation de la réponse impulsionnelle d'un réseau de câbles par déconvolution myope et s'applique notamment au domaine de la réflectométrie en électronique.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir tester leur état et d'apporter des informations sur la détection de défauts, mais aussi leur localisation et leur type, afin d'aider à la maintenance et à la prévention. Pour cela, des méthodes dites de réflectométrie sont mises en oeuvre. Celles-ci peuvent aussi être utilisées pour détecter les défauts d'un réseau de fibres optiques.

Le principe de la réflectométrie repose sur l'injection d'un signal test. La forme de ce signal change significativement lors de sa propagation aller-retour dans un câble, ces changements étant la conséquence des phénomènes physiques d'atténuation et de dispersion.

Les méthodes de réflectométrie utilisent un principe proche de celui du radar : un signal électrique, le signal de test, souvent large bande, est injecté en un ou plusieurs endroits du câble à tester. Ledit signal se propage dans le câble ou le réseau et renvoie une partie de son énergie lorsqu'il rencontre une discontinuité électrique. Une discontinuité électrique peut résulter, par exemple, d'une jonction, de la fin du câble ou d'un défaut. L'analyse des signaux renvoyés au point d'injection permet d'en déduire des informations sur la présence et la localisation de ces discontinuités, donc des défauts éventuels. L'analyse des signaux réfléchis permet de détecter des singularités, c'est-à-dire des ruptures d'impédance caractéristique du câble, ces dernières pouvant aussi correspondre à des défauts.

Le signal résultant de la réflectométrie est appelé réflectogramme et est constitué d'une pluralité de pics correspondant aux singularités du réseau. Il peut y avoir plusieurs pics par singularité, certains correspondants à des réflexions multiples. Dans un réseau complexe, l'objectif est alors de déterminer quel pic correspond à un défaut puis d'isoler correctement celui-ci afin de localiser précisément ledit défaut.

Afin de pouvoir détecter un défaut au sein d'un réseau arbitrairement complexe, il convient de mesurer les variations de la réponse électrique dudit réseau. La difficulté est ensuite d'identifier le pic correspondant au défaut afin de pouvoir le localiser.

Dans les systèmes embarqués de contrôle non destructif et en particulier pour le diagnostic filaire par réflectométrie, la bande passante des systèmes est limitée. Or l'objectif recherché est d'obtenir des signaux avec la meilleure résolution possible, la résolution dépendant directement de la bande passante. Afin d'optimiser cette résolution, divers traitements se basant sur une déconvolution de signaux peuvent être appliqués. Dans le cas de la réflectométrie, des traitements haute résolution sont connus, comme ceux présentés dans l'article de C. Buccella, M. Feliziani et G. Manzi intitulé Detection and localization of defects in shielded cables by time-domain measurements with uwb pulse injection and clean algorithm postprocessing, IEEE Transactions on Electromagnetic Compatibility, 46(4), pages 597-605, Novembre 2004, ainsi que dans l'article de S. Schuet intitulé Wiring diagnostics via l1 - regularized least squares, Sensors Journal, IEEE, 10(7) pages 1218-1225, Juillet 2010. Les méthodes dites « haute résolution » correspondent à des traitements permettant d'améliorer l'estimation des temps de retard dans le réflectogramme et de distinguer les uns par rapport aux autres plusieurs pics pouvant être très proches. Ces traitements peuvent être intégrés dans un système embarqué, mais ils ne tiennent pas compte des divers phénomènes de distorsions linéaires qui altèrent le signal, ces derniers étant généralement inconnus. Ces phénomènes de distorsions linéaires sont la conséquence, par exemple, de la dispersion dans les câbles du réseau à tester et des caractéristiques des composants du système de mesure par réflectométrie qui agissent comme des filtres passe-bas.

La prise en compte de ces distorsions permet d'améliorer la résolution. Ces distorsions étant inconnues, il est requis de mettre en oeuvre des méthodes de déconvolution myope, appelées également méthodes semi-aveugles. Plusieurs méthodes de ce type existent, comme décrit dans l'article de O. Rosec, J. M. Boucher, B. Nsiri et T. Chonavel intitulé Blind marine seismic deconvolution using statistical mcmc methods, IEEE Journal of Oceanic Engineering, 28(3), pages 502-512, juillet 2003. Un inconvénient des méthodes existantes est qu'elles nécessitent une quantité importante de calculs ce qui rend difficile leur intégration dans un système de réflectométrie.

La publication de demande de brevet GB 2 458 654 A a pour objet un procédé de réflectométrie temporelle.

Un but de l'invention est notamment de pallier les inconvénients précités.

A cet effet l'invention a pour objet un procédé d'estimation de la réponse impulsionnelle $h(t)$ d'un réseau de câbles par déconvolution myope, un signal de test $s(t)$ étant introduit en un point d'entrée du réseau et un signal $y(t)$ étant mesuré en un point de sortie du réseau le point d'entrée et le point de sortie étant de préférence les mêmes. Le procédé comprend une étape d'estimation initiale de la réponse impulsionnelle $h(t)$ par déconvolution du signal $y(t)$ avec un noyau correspondant au signal de test $s(t)$, une étape d'estimation d'un noyau de déconvolution $g(t)$ en utilisant le résultat de l'estimation initiale de la réponse impulsionnelle $h(t)$, ledit noyau prenant en compte les distortions $\xi(t)$ introduites par le réseau. Le procédé comprend en outre une étape (302) d'estimation affinée de $h(t)$ par déconvolution en utilisant le noyau $g(t)$.

Selon un aspect de l'invention, l'estimation initiale de la réponse impulsionnelle $h$(t) est obtenue par application de l'algorithme CLEAN.

L'estimation affinée de $h(t)$ est obtenue, par exemple, par déconvolution L1.

Selon un autre aspect de l'invention, il est pris comme hypothèse dans l'étape d'estimation du noyau de déconvolution $g(t)$ que la fonction $\xi(t)$ est centrée autour de l'instant $t = 0$.

Dans un mode de réalisation, le noyau de déconvolution $g(t)$ est obtenu par contruction et résolution d'un système tridiagonal, ce sytème correspondant à l'expression :

$$\underline{g} = F^H \left( FH^H HF^H + \mu_1 I + \mu_2 D^H D \right)^{-1} FH^H \underline{y}.$$

dans laquelle :

g est un vecteur correspondant au noyau de déconvolution ;
$\mu_1$ et $\mu_2$ sont des paramètres réels de réglage ;
I représente la matrice identité de dimension $N \times N$ ;
H est une matrice circulante représentative de l'opération de convolution avec le vecteur $\underline{h}$ représentatif de l'estimation initiale de la réponse impulsionnelle $h(t)$;
F représente la matrice de Fourrier unitaire de dimension $N \times N$ ;
D représente une matrice diagonale de dimension NxN agencée de la manière suivante :

$$D = \begin{bmatrix} d_0 & & & & \\ -d_1 & d_1 & & & \\ & \ddots & & \ddots & \\ & & -d_{N-2} & d_{N-2} & \\ & & & -d_{N-1} & d_{N-1} \end{bmatrix}.$$

les éléments de D valant $d_0 = 0$ et $d_n = 1$ pour $n > 0$ ;
$H^H$, $F^H$ et $D^H$ représentent les matrices transposées conjuguées des matrices H, F et D.

N peut être choisi de manière à mettre en oeuvre un algorithme de transformée de Fourier rapide tel que Radix-2.

Le système tridiagonal est résolu, par exemple, en utilisant l'algorithme de Thomas.

Selon un mode de réalisation, après l'estimation initiale de la réponse impulsionnelle $h(t)$, les étapes d'estimation du noyau $g(t)$ et d'estimation affinée de $h(t)$ sont appliquées successivement et de manière itérative.

L'invention concerne aussi un dispositif de réflectrométrie comprenant des moyens pour générer un signal de test $s(t)$, le transmettre dans un réseau à tester, mesurer un signal $y(t)$ résultant du parcours de $s(t)$ dans le réseau, analyser le signal $y(t)$. Le dispositif comporte des moyens pour mettre en oeuvre le procédé selon l'une quelconque des revendications précédentes.

D'autres caractéristiques et avantages de l'invention apparaîtront à l'aide de la description qui suit donnée à titre illustratif et non limitatif, faite en regard des dessins annexés parmi lesquels :

- la figure 1 présente une modélisation des phénomènes modifiant un signal de test lors de sa propagation dans un réseau testé à l'aide d'un système de réflectométrie ;
- la figure 2 donne un exemple de réflectogramme haute résolution obtenu par simulation avec et sans prise en compte de la distorsion $\underline{\xi}$ ;
- la figure 3 donne un exemple simplifié de procédé de déconvolution selon l'invention ;
- la figure 4 présente des résultats de simulation relatifs à la mise en oeuvre de la déconvolution myope selon l'invention ;
- la figure 5 donne un exemple de réflectogramme obtenu par application du procédé selon l'invention.

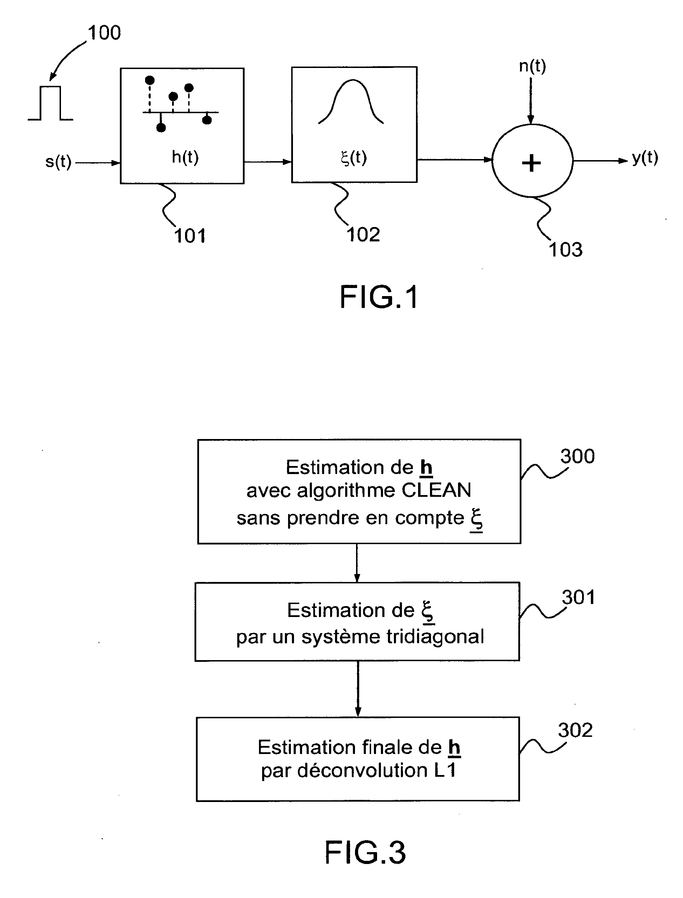

La figure 1 présente une modélisation des phénomènes modifiant le signal de test lors de sa propagation dans un réseau testé à l'aide d'un système de réflectométrie.

Un signal noté $y(t)$ correspond au signal mesuré par le système de réflectométrie résultant notamment de la propagation du signal de test dans le réseau et peut être modélisé en utilisant l'expression suivante :

$$y(t) = s(t) * h(t) * \xi(t) + n(t) \qquad (1)$$

dans laquelle :

* représente l'opération de produit de convolution ;
$s(t)$ représente le signal de test 100 ;
$h(t)$ représente le signal recherché par le système de réflectométrie et correspond à la réponse impulsionnelle 101 du réseau testé ;
$\xi(t)$ représente divers phénomènes de filtrage 102, pas nécessairement connus, liés entre autre à la limitation de bande passante des divers éléments et composants présents sur le trajet de l'onde correspondant au signal de test ;
$n(t)$ représente un bruit addtif de mesure 103.

Le signal $h(t)$ est composé d'une série de pics dont les positions donnent les retards des différentes réflexions du signal de test, appelés aussi échos et peut être décrit à l'aide de l'expression suivante :

$$h(t) = \sum_{k>0} \alpha_k \delta(t - \tau_k), \qquad (2)$$

dans laquelle :

$\alpha_k$ représente l'amplitude des échos ;
$\tau_k$ représente les retards associés aux échos ;
$\delta(t)$ représente la distribution de Dirac.

Le signal $h(t)$ appartient à la catégorie des signaux parcimonieux car il possède peu de valeurs non nulles.

La fonction $\xi(t)$ est appelée dans la suite de la description fonction de distorsion. Cette fonction correspond habituellement à un filtre passe-bas 102 dont les caractéristiques ne sont pas connues. C'est pour cette raison que l'effet de ce filtre est souvent négligé par les systèmes de réflectométrie au détriment de la précision de localisation des défauts du réseau testé.

Le procédé décrit ci-après a notamment pour objectif d'estimer la fonction de distortion $\xi(t)$ par des méthodes de traitement pouvant être embarquées dans un système de réflectométrie, cette estimation étant ensuite utilisée afin de compenser cette distorsion.

Le signal mesuré $y(t)$ est habituellement traité dans un système de réflectométrie par filtrage adapté, ce qui est équivalent à une intercorrélation entre $y(t)$ et le signal test $s(t)$.

Le signal $r(t)$ obtenu en sortie de ce filtre peut être décrit en utilisant l'expression :

$$r(t) = r_{ss}(t) * h(t) \qquad (3)$$

dans laquelle :

$r_{ss}(t)$ est la fonction d'autocorrélation de $s(t)$.

Il est supposé ici que le signal émis $s(t)$ est choisi de manière à avoir une autocorrélation en forme de triangle en suivant l'expression suivante :

$$r_{ss}(n) = \begin{cases} \dfrac{K - |n|}{K} & si \ |n| < K \\ 0 & sinon \end{cases} \qquad (4)$$

dans laquelle :

*K* est une constante réelle ;
*n* représente l'index des échantillons du signal.

Lorsque la fonction de distorsion *g(t)* n'est pas prise en compte, c'est-à-dire que l'on pose $\xi(t) = 1$, l'élimination de *s(t)* dans l'expression (1) constitue un problème de déconvolution classique. En effet, dans ce cas de figure, le noyau de déconvolution est égal à *s(t)* et est quant à lui connu. Dans ce contexte, le principe de ces algorithmes s'appuie sur le caractère parcimonieux du signal *h(t)* à retrouver et entre dans la catégorie des méthodes de déconvolution impulsionnelle. Parmi les méthodes les mieux adaptées au contexte des systèmes embarqués, on peut mentionner l'algorithme CLEAN également désigné par l'expression anglo-saxonne « Matching Pursuit » et décrit dans l'article de C. Buccella, M. Feliziani et G. Manzi intitulé Detection and localization of defects in shielded cables by time-domain measurements with uwb pulse injection and clean algorithm postprocessing, IEEE Transactions on Electromagnetic Compatibility, 46(4), pages 597-605, Novembre 2004. On peut également citer les algorithmes de déconvolution L1 tels que l'algorithme IST venant de l'expression anglo-saxonne « Iterative Soft Thresholding » ou encore l'algorithme IST rapide appelé aussi Fast-IST et dont on trouvera les descriptions et comparaisons dans l'article de I. Loris, M. Bertero, C. De Mol, R. Zanella et L. Zanni intitulé Accelerating gradient projection methods for l1-constrained signal recovery by steplength selection rules, Applied and Computational Harmonie Analysis, 27(2), pages 247-254, 2009.

Au lieu de prendre le signal test directement comme noyau de déconvolution, la prise en compte de la distorsion dans ce noyau permet d'améliorer nettement les résultats fournis en terme de résolution. Cette prise en compte de la distorsion permet d'obtenir un noyau relativement lisse dans le domaine temporel en raison de la nature passe-bas de la distorsion. Ce dernier est en effet prévu pour des formes de signal plus abrupte, ce qui était le cas du noyau en forme de triangle précédemment étudié.

A titre de remarque préliminaire, dans la suite de la description, une notation du type $\underline{x}$ désigne un vecteur, c'est-à-dire un ensemble de valeurs organisées dans une matrice comprenant une seule colonne. De manière générale dans la description, un vecteur $\underline{x}$ correspond à un ensemble d'éléments discrets représentatifs d'une fonction *x(t)*. De plus, une matrice notée **X** est une matrice circulante correspondant à l'opération de convolution avec le vecteur $\underline{x}$.

On utilise, par exemple, dans le cadre du procédé une déconvolution de type L1 pour l'estimation d'un secteur $\underline{h}$ représentatif de la fonction *h(t)*. Cela revient à minimiser une fonction $J_{L1}(\underline{h})$ pouvant s'exprimer, par exemple, en utilisant l'expression :

$$J_{L1}(\underline{h}) = \left\| \underline{y} - \mathbf{G}\underline{h} \right\|_2^2 + \mu \left\| \underline{h} \right\|_1 \qquad (5)$$

dans laquelle :

$\left\| \underline{h} \right\|_1 = \sum_{n \geq 0} \left| h_n \right|$ est la norme L1 de $\underline{h}$, l'utilisation de cette norme favorise les solutions $\underline{h}$ à caractère parcimonieux ;

$\mu$ est une constante réelle permettant d'introduire un compromis entre la fidélité de l'estimation à la mesure et son adéquation au modèle, ce dernier pouvant être réglé de manière empirique ;

**G** est une matrice circulante correspondant à l'opération de convolution avec le noyau représenté par le vecteur $\underline{g}$ correspondant à la fonction *g(t)*, ledit noyau correspondant au produit de convolution du signal test *s(t)* avec la fonction de distorsion $\xi(t)$.

La matrice **G** peut s'écrire en utilisant l'expression :

$$\mathbf{G} = \mathbf{S}\Xi \qquad (6)$$

dans laquelle :

**S** représente une matrice circulante correspondant à l'opération de convolution avec $\underline{s}$, vecteur représentatif de la fonction *s(t)* ;

$\Xi$ représente une matrice circulante correspondant à l'opération de convolution avec $\underline{\xi}$, vecteur représentatif de la fonction de distortion $\xi(t)$.

C'est donc dans la matrice **G** que la distorsion est prise en compte. Dans le cas où la distorsion est ignorée on a **G** = **S**.

La figure 2 donne un exemple de réflectogramme obtenu par simulation avec et sans prise en compte de la distorsion $\xi$. Cette figure permet d'illustrer le gain de performance induit par la prise en compte de la distorsion dans un exemple de configuration choisi. Dans cet exemple, la fonction de distorsion est supposée connue dans la mesure ou elle est créée artificiellement dans un simulateur. Cette dernière correspond ici à cinq filtres du premier ordre ordonnés en cascade. Sa transformée de Laplace, $\Xi(jw)$, peut être décrite en utilisant l'expression suivante :

$$\Xi(j\omega) = \prod_{n \geq 0} \frac{1}{1 + j\omega / \omega_n}, \qquad (7)$$

dans laquelle :

$\omega_n$ représente la n-ième pulsation de coupure.

Le choix de ce modèle est lié au fait que la plupart des phénomènes observés expérimentalement sur le trajet du signal s'apparentent à un filtre du premier ordre. Sur la figure 2 apparaissent la réponse réelle $h(t)$ 200 du réseau simulé, la fonction $r_{sy}(t)$ 201 représentant la fonction d'intercorrélation entre les signaux $s(t)$ et $y(t)$, la réponse du réseau 202 obtenue après une déconvolution classique sans prise en compte de la distorsion dans le noyau, et la réponse du réseau 203 obtenue après une déconvolution dont le noyau prend en compte la distorsion qui est ici connue. Il apparaît que la prise en compte de la distorsion améliore nettement la qualité du résultat. La résolution des pics se trouve améliorée, ce qui aura notamment pour effet de faciliter la localisation des défauts du réseau.

L'estimation de $\underline{h}$ sans la connaissance de $\xi$, vecteur représentatif de la fonction $\xi(t)$ constitue un problème de déconvolution myope dans la mesure où on ne connait que partiellement le noyau de déconvolution correspondant à la fonction $g(t) = s(t)*\xi(t)$.

Plusieurs méthodes performantes existent pour résoudre ce type de problème. Elles s'appuient habituellement sur des procédés de simulation statistique tels que la méthode de Monte-Carlo par chaîne de Markov désignée par l'acronyme MCMC venant de l'expression anglo-saxonne « Markov Chain Monte-Calo ». Cependant, ces derniers ne sont pas envisageables pour une intégration dans un système embarqué de par leur complexité.

Une approche similaire à celle de la déconvolution-L1 et correspondant à une estimation jointe de $h$ et $g$ est proposée dans l'article de S. Gautier, J. Idier, F. Champagnat, A. Mohammad-Djafari et B. Lavayssière. Intitulé Traitement d'échogrammes ultrasonores par déconvolution aveugle, GRETSI, 1997.

Elle consiste à optimiser une fonction de coût du type :

$$J_1\left(\underline{h}, \underline{g}\right) = \left\|\underline{y} - C\left(\underline{g}\right)\underline{h}\right\|_2^2 + \mu_1\left\|\underline{h}\right\|_1 + \mu_2\left\|Q\underline{g}\right\|_2 + \mu_3\left\|\underline{g}\right\|_2 \qquad (8)$$

dans laquelle :

le signe $\|\cdot\|_1$ fait référence à la norme L1 ;
le signe $\|\cdot\|_2$ fait référence à la norme L2 ;
$\mu_1$, $\mu_2$ et $\mu_3$ sont des paramètres de régularisation ;
**Q** est une matrice permettant de favoriser des solutions douces de $\underline{g}$ ;

En revanche, le deuxième terme associé a paramètre $\mu_1$ favorise les solutions de $\underline{h}$ de nature parcimonieuse. Enfin, le dernier terme limite l'énergie de $\underline{g}$ et améliore ainsi le conditionnement de l'estimateur.

En pratique, la minimisation de $J_1$ ($\underline{h},\underline{g}$) peut se faire en alternant les variations de $\underline{g}$ et de $\underline{h}$. Ce type d'approche est utilisé pour de la déconvolution d'image. Néanmoins l'inconvénient de cette méthode est qu'elle peut s'avérer longue à converger. De plus, les paramètres $\mu_1$ et $\mu_2$ sont fortement dépendant ce qui peut rendre délicat leur réglage en pratique.

La méthode proposée dans le cadre de l'invention emploie une stratégie innovante consistant à approcher les deux fonctions inconnues $\underline{h}$ et $\xi$ par approximations successives. Ainsi, une première déconvolution sans prise en compte de la distorsion est effectuée aboutissant à une estimation notée $\underline{h}^{(0)}$ de la réponse impulsionnelle. En utilisant ce premier résultat, la fonction de distorsion peut être à son tour estimée par moindres carrés. Pour cela, une fonction $J_2()$ définie ci-dessous peut être minimisée, celle-ci pouvant être déterminée en utilisant l'expression suivante :

$$J_2\left(\underline{\xi}\right) = \left\|\underline{y} - \mathbf{HS}\underline{\xi}\right\|_2^2 \qquad\qquad (9)$$

dans laquelle :

H est une matrice circulante représentative de l'opération de convolution avec le vecteur $\underline{h}$ ;

$\underline{\xi}$ est le vecteur correpondant à la fonction de distorsion nouvellement acquise et peut être introduite dans le noyau de déconvolution et obtenir une nouvelle estimation $\underline{h}^{(1)}$ de la réponse impulsionnelle.

Le procédé est itératif. Ainsi un nombre choisi d'itérations est appliqué afin de converger vers une approximation acceptable des deux fonctions $\underline{h}$ et $\underline{\xi}$.

Cette stratégie fonctionne dans des cas où l'on possède plusieurs signaux différents avec la même distorsion ou bien si le signal possède suffisemment de pics bien séparables. Or, dans le cas du diagnostic de câbles, on ne dispose pas de suffisamment de données à traiter et on observe de trop nombreux cas où la méthode est très longue à converger ou bien diverge.

Le procédé selon l'invention a notamment pour objectif l'estimation de $\underline{\xi}$ afin d'éviter d'avoir à appliquer un nombre trop important d'itérations ou de piéger la convergence dans des solutions erronées. Cela se fait en introduisant des hypothèses sur la nature de $\underline{\xi}$. Une hypothèse pouvant être choisie et utilisée est de considérer que l'essentiel de l'énergie de $\underline{\xi}$ dans le domaine temporel est concentrée autour de l'instant $t = 0$. Cette hyppothèse vient du fait qu'il n'est pas possible d'estimer le retard de groupe du filtre de distorsion $\underline{\xi}$. Il est donc supposé que cette fonction $\underline{\xi}$ est centrée autour de l'instant $t = 0$, appelé origine des temps dans la suite de la description. On considére donc que l'énergie est concentrée autour de ce point.

Le procédé selon l'invention cherche ici à pénaliser dans une fonction de coût les valeurs importantes de $\underline{\xi}$ qui apparaissent, dans le domaine temporel sur des échantillons éloignés de l'origine. En d'autres termes, des solutions de $\underline{\xi}$ dont la dérivée dans le domaine temporel n'excède pas un niveau choisi sont favorisées. En considérant la transformée de Fourier, cela se traduit par des variations rapides en certains points. En effet, les points de plus en plus éloignés de l'origine dans le domaine temporel correspondent à des variations de plus en plus rapide de la transformée de Fourier. Cette erreur peut donc être réduite en appliquant une contrainte de lissage sur la transformée de Fourier discrète $G_n$ de l'estimation de $\mathbf{g}$, ce qui revient à pénaliser la dérivée à travers une fonction de coût à minimiser.

En valeurs discrètes, la dérivée $\Delta G_n$ de la transformée de Fourrier discrète TFD peut être représentée en utilisant l'expression :

$$\Delta G_n \cong G_n - G_{n-1} \qquad\qquad (10)$$

dans laquelle :

$G_n$ et $G_{n-1}$ représentent les échantillons de la transformée TFD de $\mathbf{g}$ d'indices respectifs n et n-1.

L'estimation peut alors se faire en minimisant une fonction $J(\ )$ :

$$J(G_n) = \sum_{n=0}^{N-1}\left[\left(Y_n - H_n G_n\right)^2 + \mu_1 G_n^2 + \mu_2\left(\Delta G_n\right)^2\right] \qquad\qquad (11)$$

dans laquelle :

$\mu_1$ et $\mu_2$ sont des paramètres de régularisation pouvant être réglés manuellement en fonction du niveau de bruit et des caractéristiques spectrales des signaux ; le paramètre le plus important est $\mu_2$ du fait qu'il conditionne l'action de la dérivée et qu'il est essentiellement lié à la largeur de spectre du signal test $s$.

L'expression (11) peut être écrite sous forme matricielle :

$$J\left(\mathbf{g}\right) = \left\|\underline{y} - \mathbf{Hg}\right\|_2^2 + \mu_1\left\|\underline{g}\right\|_2^2 + \mu_2\left\|\mathbf{DFg}\right\|_2^2 \qquad\qquad (12)$$

dans laquelle :

$$\mathbf{D} = \begin{bmatrix} d_0 & & & & \\ -d_1 & d_1 & & & \\ & \ddots & & \ddots & \\ & & -d_{N-2} & d_{N-2} & \\ & & & -d_{N-1} & d_{N-1} \end{bmatrix}.$$

les éléments de cette matrice étant définis ci-après ;

F représente la matrice de Fourrier unitaire et peut s'écrire :

$$\mathbf{F} = \frac{1}{\sqrt{N}} \begin{bmatrix} 1 & 1 & 1 & \cdots & 1 \\ 1 & w_N & w_N^2 & \cdots & w_N^{N-1} \\ \vdots & \vdots & \vdots & \cdots & \vdots \\ 1 & w_N^{N-1} & w_N^{2(N-1)} & \cdots & w_N^{(N-1)(N-1)} \end{bmatrix}, \; avec : w_N^n = e^{-j2\pi\frac{n}{N}}.$$

$\mathbf{g}$ représente la fonction recherchée dans le domaine temporel, correspondant au noyau de déconvolution.

L''utilisation de la matrice **F** permet d'exprimer la transformée de Fourier, ainsi **DFg** correspond à la dérivée de la transformée de Fourier du noyau. En général, on appliquera la contrainte de dérivé sur l'ensemble du signal à l'exception de la composante continue. Par conséquent $d_0 = 0$ et $d_n = 1$ pour $n > 0$. Cette fonction de coût correspond à une régularisation de Tychonoff_comme décrit dans l'ouvrage de A. N. Tychonoff et V. Y. Arsenin intitulé Solution of Ill-posed Problems, Washington : Winston & Sons, 1977.

En posant, $\left\| \underline{\mathbf{x}} \right\|_2^2 = \underline{\mathbf{x}}^{\mathbf{H}} \underline{\mathbf{x}}$ on peut obtenir l'expression de sa dérivée :

$$\frac{\partial J}{\partial \underline{\mathbf{g}}} = 2 \left[ \left( \mathbf{H}^{\mathbf{H}}\mathbf{H} + \mu_1 \mathbf{I} + \mu_2 \mathbf{F}^{\mathbf{H}}\mathbf{D}^{\mathbf{H}}\mathbf{D}\mathbf{F} \right) \underline{\mathbf{g}} - \mathbf{H}^{\mathbf{H}} \underline{\mathbf{y}} \right]. \qquad (13)$$

Cette dérivée s'annule pour :

$$\underline{\mathbf{g}} = \left( \mathbf{H}^{\mathbf{H}}\mathbf{H} + \mu_1 \mathbf{I} + \mu_2 \mathbf{F}^{\mathbf{H}}\mathbf{D}^{\mathbf{H}}\mathbf{D}\mathbf{F} \right)^{-1} \mathbf{H}^{\mathbf{H}} \underline{\mathbf{y}}. \qquad (14)$$

La minimisation de la fonction $J(\mathbf{g})$ peut donc se faire par calcul direct. L'inversion peut se faire dans la base de Fourier afin de diagonaliser les matrices circulantes, comme c'est le cas pour la division spectrale, il vient alors l'expression suivante :

$$\underline{\mathbf{g}} = \mathbf{F}^{\mathbf{H}} \left( \mathbf{F}\mathbf{H}^{\mathbf{H}}\mathbf{H}\mathbf{F}^{\mathbf{H}} + \mu_1 \mathbf{I} + \mu_2 \mathbf{D}^{\mathbf{H}}\mathbf{D} \right)^{-1} \mathbf{F}\mathbf{H}^{\mathbf{H}} \underline{\mathbf{y}}. \qquad (15)$$

Il convient alors de déterminer une transformée DFT avant et une DFT inverse après inversion. La matrice à inverser devient ici tridiagonale. On obtient alors l'expression suivante :

$$\mathbf{FH}^{\mathbf{H}}\mathbf{HF}^{\mathbf{H}} + \mu_1\mathbf{I} + \mu_2\mathbf{D}^{\mathbf{H}}\mathbf{D} = \begin{bmatrix} b_0 & c_1 & & & & \\ a_1 & b_1 & c_2 & & & \\ & a_2 & \ddots & \ddots & & \\ & & \ddots & \ddots & c_{N-1} \\ & & & a_{N-1} & b_{N-1} \end{bmatrix}, \qquad (16)$$

dans laquelle :

$$a_n = c_n = -d_n^2$$

$$b_n = |H_n|^2 + \mu_1 + \mu_2(d_n^2 + d_{n+1}^2),$$

les coefficient $H_n$ correspondent à la transformée DFT du vecteur $\underline{h}$, $(H_0,..,H_{N-1})^{\mathsf{T}} = \mathbf{F}\underline{h}$.

La résolution d'un système tridiagonal tel celui que présenté dans l'expression (15) peut se faire avec une complexité d'ordre N, c'est-à-dire avec un nombre de calcul proportionnel au nombre d'échantillons N du vecteur de mesure. Pour cela, on peut par exemple utiliser l'algorithme de Thomas désigné habituellement par l'acronyme TDMA venant de l'expression anglo-saxonne « TriDiagonal Matrix Algorithm ». L'algorithme de Thomas est décrit dans l'ouvrage de Pierre Borne et Frédéric Rotella intitulé Théorie et pratique du calcul matriciel, Editions TECHNIP, 1995. Le surcoût en terme de puissance de calcul nécessaire engendré par l'ajout de la dérivée par rapport à une division spectrale reste donc raisonnable.

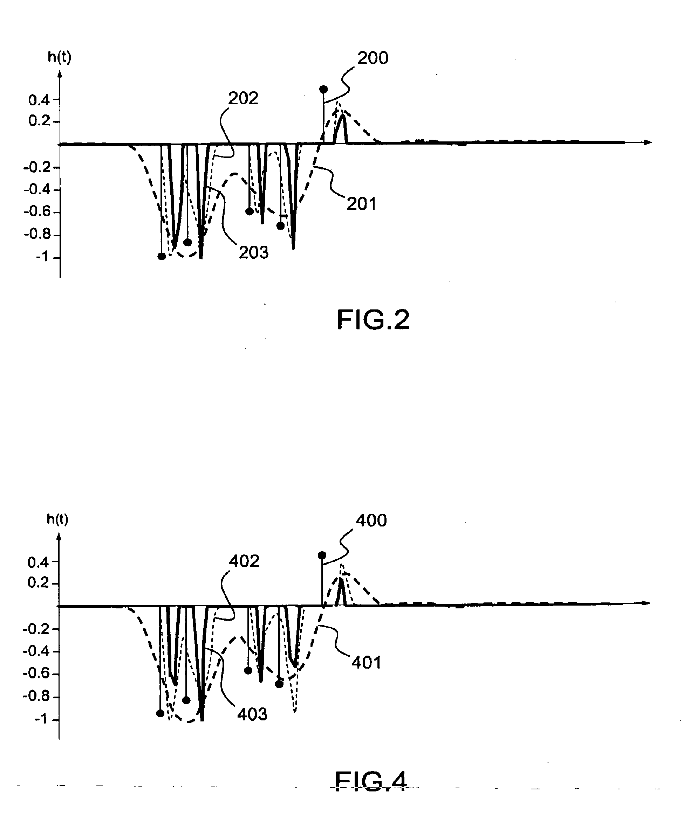

En résumé, le procédé de déconvolution myope peut être décomposé en trois étapes comme illustré avec la figure 3.

Une première étape 300 correspond à une première estimation de $\underline{h}$ par l'algorithme CLEAN en utilisant comme noyau le signal de test s(t).

Une seconde étape 301 correspond à une estimation de $\underline{g}$. Le noyau est calculé dans le domaine fréquentiel par la résolution du système tridiagonal comme celui de l'expression (15). Cette seconde étape peut être mise en oeuvre à l'aide de trois opérations principales. Une première opération correspond à l'application d'une transformée de Fourier discrète TFD, par exemple sur N points. Avantageusement, on choisit une valeur de N permettant l'utilisation d'un algorithme de transformée de Fourier rapide tel que Radix-2 dans le cas où N est une puissance de 2. Une seconde opération correspond à la construction du système tridiagonal de dimension N/2. Une troisième opération correspond à la résolution du système tridiagonal de dimension N/2.

Une troisième étape 302 du procédé correspond à une estimation finale de $\underline{h}$ par déconvolution-L1 en minimisant une fonction $J_{L1}(\underline{h})$.

Avantageusement, l'intégration en virgule fixe dans un circuit électronique de ce procédé décrit précédemment est envisageable.

Les courbes visibles figure 4 donnent un exemple de résultat de simulation de la déconvolution myope selon l'invention. Sur cette figure apparaissent la réponse réelle h(t) 400 de réseau, la fonction $r_{sy}$(t) 401 représentant la fonction d'intercorrélation entre les signaux s(t) et y(t), la réponse du réseau 402 obtenue après une déconvolution classique sans prise en compte de la distorsion dans le noyau, et la réponse du réseau 403 obtenue après une déconvolution dont le noyau prend en compte la distorsion estimée.

Le résultat obtenu est légèrement moins bon que dans l'exemple de la figure 2 lorsque la fonction de distorsion est connue, mais on observe de manière indiscutable une nette amélioration par rapport au cas où la distorsion est ignorée.

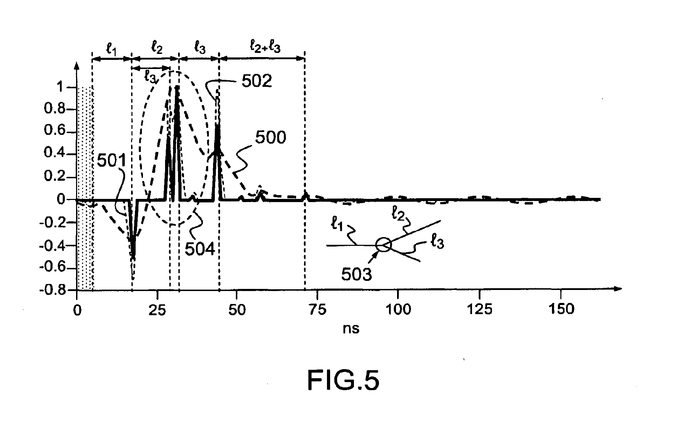

La figure 5 donne un exemple de réflectogramme obtenu par application du procédé selon l'invention.

Sur cette figure, la fonction $r_{sy}$(t) mesurée 500 représentant la fonction d'intercorrélation entre les signaux s(t) et y(t), la réponse du réseau 501 obtenue après une déconvolution classique sans prise en compte de la distorsion dans le noyau, et la réponse du réseau 502 obtenue après une déconvolution myope mettant en oeuvre l'invention.

Dans cet exemple, le procédé est appliqué au test d'un réseau en Y. Lorsque l'onde atteint la jonction centrale 503 du réseau, une onde de polarité négative est réfléchie, et lorsqu'elle atteint chacun des deux bouts de branche $l_2$ et $l_3$ qui sont en circuit ouvert, une onde positive est réfléchie. Une fraction résiduelle de l'onde continue ensuite à se propager dans le réseau donnant lieu à des échos secondaires.

Afin de faire le lien entre les signaux obtenus et la propagation des ondes réfléchies, on relie la distance et le temps par l'expression :

$$\tau = \frac{2x}{v}, \qquad\qquad\qquad (17)$$

dans laquelle :

x représente la distance en mètres ;
$\tau$ représente le temps d'aller-retour de l'onde en secondes ;
v représente la vitesse de propagation, dans le cas des câbles utilisés pour l'expérimentation, celle-ci vaut $v = 2 \cdot 10^5$ $km.s^{-1}$.

Dans le cas de ce réseau, les longueurs des deux branches $l_2$ et $l_3$ sont très proches, il est donc difficile de distinguer 504 les deux bouts. On constate ici que la méthode haute résolution proposée permet de faire cette distinction contrairement à une déconvolution classique ne prenant pas en compte la distorsion.

## Revendications

1. Procédé d'estimation de la réponse impulsionnelle $h(t)$ d'un réseau de câbles par déconvolution myope,
   un signal de test $s(t)$ étant introduit en un point d'entrée du réseau et étant affecté par des distorsions, inconnues a priori et représentées par une fonction de distorsion $\xi(t)$, et
   un signal $y(t)$ étant mesuré en un point de sortie du réseau, le point d'entrée et le point de sortie étant de préférence les mêmes,
   le signal mesuré $y(t)$ étant modélisé par l'expression suivante :

$$y(t) = s(t) * h(t) * \xi(t) + n(t)$$

   dans laquelle :

   * représente l'opération de produit de convolution et $n(t)$ représente un bruit addtif de mesure,

   **caractérisé en ce que** le procédé comprend :

   - une première étape (300) d'estimation initiale de la réponse impulsionnelle $h(t)$ par déconvolution du signal $y(t)$ avec un noyau de déconvolution égal au signal de test $s(t)$ et correspondant à l'absence de distorsions linéaires, c'est-à-dire une fonction de distorsion $\xi(t)$ égale à l'identité ;
   - une seconde étape (301) d'estimation d'un noyau $g(t)$ de déconvolution du signal $y(t)$ en utilisant le résultat de l'estimation initiale de la réponse impulsionnelle $h(t)$, ledit noyau $g(t)$ prenant en compte les distortions $\xi(t)$ introduites par le réseau et étant égal à $s(t) * \xi(t)$;
   - une troisième étape (302) d'estimation affinée de $h(t)$ par déconvolution du signal $y(t)$ en utilisant le noyau $g(t)$ estimé dans la seconde étape (301).

2. Procédé selon la revendication 1 **caractérisé en ce que** l'estimation initiale (300) de la réponse impulsionnelle $h(t)$ est obtenue par application de l'algorithme CLEAN.

3. Procédé selon l'une quelconque des revendications précédentes **caractérisé en ce que** l'estimation affinée de $h(t)$ (302) est obtenue par une déconvolution L1 consistant en une minimisation d'une fonction comprenant un terme représentant la norme L1 de $\underline{h}$.

4. Procédé selon l'une quelconque des revendications précédentes **caractérisé en ce qu**'il est pris comme hypothèse dans l'étape (301) d'estimation du noyau de déconvolution $g(t)$ que la fonction $\xi(t)$ est centrée autour de l'instant $t = 0$.

5. Procédé selon la revendication 4 **caractérisé en ce que** le noyau de déconvolution $g(t)$ est obtenu par contruction et résolution d'un système tridiagonal, ce sytème correspondant à l'expression :

$$\underline{g} = F^H \left( FH^H HF^H + \mu_1 I + \mu_2 D^H D \right)^{-1} FH^H \underline{y}.$$

dans laquelle :

$g$ est un vecteur correspondant au noyau de déconvolution ;
$\mu_1$ et $\mu_2$ sont des paramètres réels de réglage ;
$I$ représente la matrice identité de dimension N$\times$N ;
$H$ est une matrice circulante représentative de l'opération de convolution avec le vecteur $\underline{h}$ représentatif de l'estimation initiale de la réponse impulsionnelle $h(t)$;
$F$ représente la matrice de Fourrier unitaire de dimension N$\times$N ;
$D$ représente une matrice diagonale de dimension NxN agencée de la manière suivante :

$$D = \begin{bmatrix} d_0 & & & & \\ -d_1 & d_1 & & & \\ & \ddots & & \ddots & \\ & & -d_{N-2} & d_{N-2} & \\ & & & -d_{N-1} & d_{N-1} \end{bmatrix}.$$

les éléments de $D$ valant $d_0 = 0$ et $d_n = 1$ pour $n > 0$ ;
$H^H$, $F^H$ et $D^H$ représentent les matrices transposées conjuguées des matrices $H$, $F$ et $D$.

6. Procédé selon la revendication 5 **caractérisé en ce que** N est choisie de manière à mettre en oeuvre un algorithme de transformée de Fourier rapide tel que Radix-2.

7. Procédé selon l'une quelconque des revendications 5 ou 6 **caractérisé en ce que** le système tridiagonal est résolu en utilisant l'algorithme de Thomas.

8. Procédé selon l'une quelconque des revendications précédentes **caractérisé en ce qu'**après l'estimation initiale (300) de la réponse impulsionnelle $h(t)$, les étapes d'estimation du noyau $g(t)$ (301) et d'estimation affinée (302) de $h$(t) sont appliquées successivement et de manière itérative.

9. Dispositif de réflectométrie comprenant des moyens pour générer un signal de test $s(t)$, le transmettre dans un réseau à tester, mesurer un signal $y(t)$ résultant du parcours de $s(t)$ dans le réseau, analyser le signal $y(t)$, **caractérisé en ce qu'**il comporte des moyens pour mettre en oeuvre le procédé selon l'une quelconque des revendications précédentes.

**Patentansprüche**

1. Verfahren zum Schätzen der Impulsantwort $h(t)$ eines Kabelnetzes durch halbblinde Entfaltung,
wobei ein Testsignal $s(t)$ an einem Eingangspunkt des Netzes eingeleitet und durch Verzerrungen beeinflusst wird, die a priori unbekannt sind und durch eine Verzerrungsfunktion $\xi(t)$ repräsentiert werden, und
wobei ein Signal $y(t)$ an einem Ausgangspunkt des Netzes gemessen wird, wobei der Eingangspunkt und der Ausgangspunkt vorzugsweise dieselben sind,
wobei das gemessene Signal $y(t)$ durch den folgenden Ausdruck modelliert wird:

$$y(t) = s(t) * h(t) * \xi(t) + n(t)$$

wobei:

* den Faltungsproduktvorgang repräsentiert und *n(t)* zusätzliches Messrauschen repräsentiert,

**dadurch gekennzeichnet, dass** das Verfahren Folgendes beinhaltet:

- einen ersten Schritt (300) des anfänglichen Schätzens der Impulsantwort *h(t)* durch Entfaltung des Signals *y(t)* mit einem Entfaltungsknoten gleich dem Testsignal *s(t)* und entsprechend der Abwesenheit von linearen Verzerrungen, d.h. eine Verzerrungsfunktion *ξ(t)* gleich der Identität;
- einen zweiten Schritt (301) des Schätzens eines Entfaltungsknotens *g(t)* des Signals *y(t)* unter Nutzung des anfänglichen Schätzergebnisses der Impulsantwort *h(t)*, wobei der Knoten *g(t)* die durch das Netz eingeführten Verzerrungen *ξ(t)* berücksichtigt, die gleich *s(t)\*ξ(t)* sind;
- einen dritten Schritt (302) des verfeinerten Schätzens von +*h(t)* durch Entfalten des Signals *y(t)* unter Nutzung des im zweiten Schritt (301) geschätzten Knotens *g*(*t*).

2. Verfahren nach Anspruch 1, **dadurch gekennzeichnet, dass** die Anfangsschätzung (300) der Impulsantwort *h(t)* durch Anwendung des CLEAN-Algouthmus erhalten wird.

3. Verfahren nach einem der vorherigen Ansprüche, **dadurch gekennzeichnet, dass** die verfeinerte Schätzung von *h(t)* (302) durch eine Entfaltung L1 bestehend aus einer Minimierung einer Funktion erhalten wird, die einen Term umfasst, der die Norm L1 von h̲ repräsentiert.

4. Verfahren nach einem der vorherigen Ansprüche, **dadurch gekennzeichnet, dass** als Hypothese in dem Schritt (301) des Schätzens des Entfaltungsknotens *g(t)* angenommen wird, dass die Funktion *ξ(t)* um den Zeitpunkt *t* = 0 herum zentriert ist.

5. Verfahren nach Anspruch 4, **dadurch gekennzeichnet, dass** der Entfaltungsknoten *g(t)* durch Konstruktion und Auflösung eines tridiagonalen Systems erhalten wird, wobei dieses System dem folgenden Ausdruck entspricht:

$$\underline{g} = \mathbf{F}^{H}\left(\overline{\mathbf{FH^{H}}}\,\overline{\mathbf{HF^{H}}} + \mu_{1}\mathbf{I} + \mu_{2}\overline{\mathbf{D^{H}D}}\right)^{-1}\mathbf{FH^{H}}\underline{y}\,,$$

wobei:

g̲ ein Vektor ist, der dem Entfaltungsknoten entspricht;
$\mu_1$ und $\mu_2$ reale Regelparameter sind;
I die Identitätsmatrix mit den Abmessungen NxN ist;
H eine zirkulierende Matrix ist, die für den Faltungsvorgang mit dem Vektor **h̲** repräsentativ ist, der die anfängliche Schätzung der Impulsantwort *h(t)* repräsentiert;
F die einheitliche Fourier-Matrix mit den Abmessungen NxN repräsentiert;
D **eine** Diagonalmatrix mit den Abmessungen NxN repräsentiert, ausgelegt auf die folgende Weise:

$$\mathbf{D} = \begin{bmatrix} d_0 & & & & \\ -d_1 & d_1 & & & \\ & \ddots & & \ddots & \\ & & -d_{N-2} & d_{N-2} & \\ & & & -d_{N-1} & d_{N-1} \end{bmatrix}$$

wobei die Elemente von **D** $d_0$ = 0 und $d_n$ = 1 für $n > 0$ sind;

$\mathbf{H^H}$, $\mathbf{F^H}$ und $\mathbf{D^H}$ die konjugierten transponierten Matrizen der Matrizen **H, F** und **D** sind.

6. Verfahren nach Anspruch 5, **dadurch gekennzeichnet, dass** N so gewählt wird, dass ein schneller Fourier-Transformationsalgorithmus wie Radix-2 umgesetzt wird.

7. Verfahren nach Anspruch 5 oder 6, **dadurch gekennzeichnet, dass** das tridiagonale System unter Anwendung des Thomas-Algorithmus aufgelöst wird.

8. Verfahren nach einem der vorherigen Ansprüche, **dadurch gekennzeichnet, dass** nach der anfänglichen Schätzung (300) der Impulsantwort $h(t)$ die Schritte des Schätzens des Knotens $g(t)$ (301) und der verfeinerten Schätzung von $h(t)$ (302) nacheinander und auf iterative Weise angewandt werden.

9. Reflektromievorrichtung, die Mittel zum Erzeugen eines Testsignals $s(t)$, zum Senden desselben in einem zu testenden Netz, zum Messen eines aus dem Laufe von $s(t)$ in dem Netz resultierenden Signals $y(t)$, zum Analysieren des Signals $y(t)$ umfasst, **dadurch gekennzeichnet, dass** sie Mittel zum Umsetzen des Verfahrens nach einem der vorherigen Ansprüche umfasst.

**Claims**

1. Method for estimating the pulsed response $h(t)$ of a cable network by means of myopic deconvolution:

   a test signal $s(t)$ being introduced at an input point of the network and being affected by distortions which are unknown a priori and which are represented by a distortion function $\xi(t)$, and
   a signal $y(t)$ being measured at an output point of the network, the input point and the output point preferably being the same,
   the measured signal $y(t)$ being modelled by the following expression:

$$y(t) = s(t) * h(t) * \xi(t) + n(t)$$

   where:

   \* represents the convolution product operation and $n(t)$ represents an additive measuring noise,

   **characterised in that** the method comprises:

   - a first step (300) of initial estimation of the pulsed response $h(t)$ by means of deconvolution of the signal $y(t)$ with a deconvolution kernel which is equal to the test signal $s(t)$ and which corresponds to the absence of linear distortions, that is to say, a distortion function $\xi(t)$ which is equal to the identity:
   - a second step (301) of estimating a kernel $g(t)$ for deconvolution of the signal $y(t)$ using the result of the initial estimation of the pulsed response $h(t)$, the kernel $g(t)$ taking into account the distortions $\xi(t)$ introduced by the network and being equal to $s(t)*\xi(t)$:
   - a third step (302) of refined estimation of $h(t)$ by means of deconvolution of the signal $y(t)$ using the kernel *g(t)* estimated in the second step (301).

2. Method according to claim 1, **characterised in that** the initial estimation (300) of the pulsed response *h(t)* is obtained by means of application of the CLEAN algorithm.

3. Method according to either of the preceding claims, **characterised in that** the refined estimation of *h(t)* (302) is obtained by means of a deconvolution L1 which involves minimising a function which comprises a term which represents the standard L1 of $\underline{h}$.

4. Method according to any one of the preceding claims, **characterised in that** it is taken as a hypothesis in the step (301) of estimating the deconvolution kernel *g(t)* that the function $\xi(t)$ is centred around the time t = 0.

5. Method according to claim 4, **characterised in that** the deconvolution kernel *g(t)* is obtained by means of construction and resolution of a tridiagonal system, this system corresponding to the expression:

$$\underline{g} = F^H \left( FH^H HF^H + \mu_1 I + \mu_2 D^H D \right)^{-1} FH^H \underline{y}.$$

where:

$\underline{g}$ is a vector which corresponds to the deconvolution kernel;
$\mu_1$ and $\mu_2$ are real adjustment parameters;
$I$ represents the identity matrix having the dimensions NxN;
$H$ is a circulant matrix which represents the convolution operation with the vector $\underline{h}$ which represents the initial estimation of the pulsed response *h(t);*
$F$ represents the unitary Fourier matrix having the dimensions NxN;
$D$ represents a diagonal matrix which has the dimensions NxN and which is arranged in the following manner:

$$= \begin{bmatrix} d_0 & & & & \\ -d_1 & d_1 & & & \\ & \ddots & & \ddots & \\ & & -d_{N-2} & d_{N-2} & \\ & & & -d_{N-1} & d_{N-1} \end{bmatrix}.$$

the elements of $D$ being $d_0 = 0$ and $d_n = 1$ for n > 0;
$H^H$, $F^H$ and $D^H$ representing the conjugated transposed matrices of the matrices $H$, $F$ and $D$.

6. Method according to claim 5, **characterised in that** N is selected so as to implement a fast Fourrier transformation algorithm such as Radix-2.

7. Method according to either claim 5 or claim 6, **characterised in that** the tridiagonal system is resolved using the Thomas algorithm.

8. Method according to any one of the preceding claims, **characterised in that**, after the initial estimation (300) of the pulsed response *h(t),* the steps of estimating the kernel *g(t)* (301) and refined estimation (302) of *h(t)* are applied successively and in an iterative manner.

9. Reflectometry device comprising means for generating a test signal *s(t),* transmitting it in a network to be tested, measuring a signal *y(t)* which results from the path of *s(t)* in the network, analysing the signal *y(t)*, **characterised in that** it comprises means for implementing the method according to any one of the preceding claims.

FIG.1

FIG.3

FIG.2

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2458654 A

**Littérature non-brevet citée dans la description**

- **C. BUCCELLA ; M. FELIZIANI ; G. MANZI.** Detection and localization of defects in shielded cables by time-domain measurements with uwb pulse injection and clean algorithm postprocessing. *IEEE Transactions on Electromagnetic Compatibility,* Novembre 2004, vol. 46 (4), 597-605
- Wiring diagnostics via I1 - regularized least squares. **S. SCHUET.** Sensors Journal. IEEE, Juillet 2010, vol. 10, 1218-1225
- **O. ROSEC ; J. M. BOUCHER ; B. NSIRI ; T. CHONAVEL.** Blind marine seismic deconvolution using statistical mcmc methods. *IEEE Journal of Oceanic Engineering,* Juillet 2003, vol. 28 (3), 502-512
- **I. LORIS ; M. BERTERO ; C. DE MOL ; R. ZANELLA ; L. ZANNI.** Accelerating gradient projection methods for I1-constrained signal recovery by steplength selection rules. *Applied and Computational Harmonie Analysis,* 2009, vol. 27 (2), 247-254
- **S. GAUTIER ; J. IDIER ; F. CHAMPAGNAT ; A. MOHAMMAD-DJAFARI ; B. LAVAYSSIÈRE.** Traitement d'échogrammes ultrasonores par déconvolution aveugle. GRETSI, 1997
- **A. N. TYCHONOFF ; V. Y. ARSENIN.** Solution of III-posed Problems, Washington. Winston & Sons, 1977
- TriDiagonal Matrix Algorithm. **PIERRE BORNE ; FRÉDÉRIC ROTELLA.** Théorie et pratique du calcul matriciel. 1995